# EUROPEAN PATENT APPLICATION

(11) **EP 1 918 988 A2**
(43) Date of publication of application: **07.05.2008**
(21) Application number: 07119541.6
(22) Date of filing: 29.10.2007
(51) Int. Cl.: H01L 21/56, H01L 23/495

(54) **A semiconductor package manufacturing method and semiconductor apparatus**

(30) Priority: 01.11.2006 KR 20060107049
(71) Applicant: Integrant Technologies Inc., Seongnam-shi Kyonggi do 463-810 (KR)
(72) Inventor: Seok, Phyo Tchun, Yongin-si Gyeonggi-do (KR); Kyung, Oh Kim, Seoul (KR)
(74) Representative: Zardi, Marco

(57) **Abstract**

Provided is a semiconductor package manufacturing method. The method comprises forming a metal circuit pattern on a substrate; connecting an integrated circuit unit to the metal circuit pattern; forming a resin on the substrate, the metal circuit pattern and the integrated circuit unit; and removing the substrate.

## Description

### Field of application

The present invention relates to semiconductor package manufacturing method and semiconductor apparatuses comprising the semiconductor package manufactured by the method.

### Prior art

A semiconductor package is classified into an interposition type and a surface mount technology(SMT) type by the method of mounting on a mother board. Dual in-line package(DIP) and Pin grid array(PGA) are classified into the interposition type. Quad flat package(QFP), Plastic leaded chip carrier(PLCC), Ceramic leaded chip carrier(CLCC), and Ball grid array(BGA) are classified into the surface mount technology(SMT) type.

The surface mount technology type semiconductor package has merits compared with the interposition type semiconductor package in aspects of an area, a thickness, a weight, and an operational velocity.

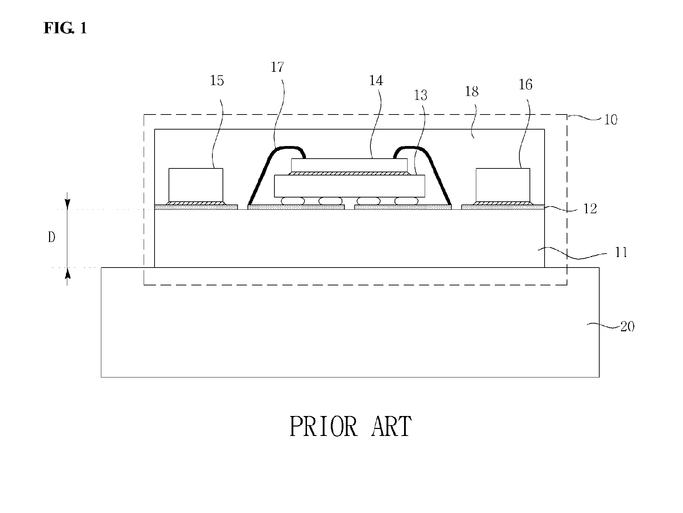

FIG. 1 is a cross sectional diagram illustrating a conventional semiconductor apparatus whose semiconductor package is mounted on a mother board in a surface mount technology type. Referring to FIG. 1, an electrical conductive pattern 12 is formed on a package substrate 11 having a thickness D of about 0.32 mm. A first integrated circuit chip 13 is electrically connected to the electrical conductive pattern 12 by flip chip bonding. The bonding wire 17 electrically connects the second integrated circuit chip 14 to the electrical conductive pattern 12. A passive device 15 and an active device 16 are electrically connected to the electrical conductive pattern 12. A sealing material 18 is formed on the package substrate 11. The above described semiconductor package 10 is mounted on a mother board 20 and is driven by a signal through electrical circuit wires(not shown) formed in the package substrate 11 and the mother board 20.

However, there is a problem that the thickness D of the package substrate 11 is a serious obstacle to miniaturization of the semiconductor apparatus.

The problem is more serious in the semiconductor apparatus manufactured by System in package(SIP) technology, where various kinds of functional chips are packaged.

### Summary of the invention

Accordingly, the present invention is to decrease the size of a semiconductor package and a semiconductor apparatus comprising the semiconductor package.

In an aspect, there is provided a semiconductor package manufacturing method. The method comprises forming a metal circuit pattern on a substrate; connecting an integrated circuit unit to the metal circuit pattern; forming a resin on the substrate, the metal circuit pattern and the integrated circuit unit; and removing the substrate.

The resin may be formed such that the resin is attached to at least a portion of the metal circuit pattern and at least a portion of the integrated circuit unit, the resin physically connecting the integrated circuit unit to the metal circuit pattern.

The integrated circuit unit may comprise at least one integrated circuit chip.

The integrated circuit unit may comprise a first integrated circuit chip and a second integrate circuit chip. And the first integrated circuit chip may be flip chip bonded to the metal circuit pattern. And the second integrated circuit chip may be wire bonded to the metal circuit pattern.

The semiconductor package manufacturing method may further comprise connecting at least one of an active device and a passive device to the metal circuit pattern.

In one aspect, there is provided a semiconductor apparatus. The apparatus comprises a semiconductor package and a mother board. The semiconductor package comprises a metal circuit pattern, an integrated circuit unit and a resin. The integrated circuit unit is connected to the metal circuit pattern. The resin is formed on the metal circuit pattern and the integrated circuit unit. The mother board comprises a package circuit wire and a mother board circuit wire. The package circuit wire is connected to the metal circuit pattern. The mother board circuit wire is connected to the package circuit wire.

The package circuit wire may be an electrically connecting means for driving the semiconductor package.

The resin may be formed such that the resin is attached to at least a portion of the metal circuit pattern and at least a portion of the integrated circuit unit, the resin physically connecting the integrated circuit unit to the metal circuit pattern.

The integrated circuit unit may comprise at least one integrated circuit chip.

The integrated circuit unit may comprise a first integrated circuit chip and a second integrated circuit chip. The first integrated circuit chip may be flip chip bonded to the metal circuit pattern. The second integrated circuit chip may be wire bonded to the metal circuit pattern.

In another aspect, there is provided a semiconductor apparatus. The apparatus comprises a semiconductor package, a mother board and a package circuit wire substrate. The semiconductor package comprises a metal circuit pattern, an integrated circuit unit and a resin. The integrated circuit unit is connected to the metal circuit pattern. The resin is formed on the metal circuit pattern and the integrated circuit unit. The mother board comprises a groove and a mother board circuit wire. The package circuit wire substrate is mounted on the groove. The package circuit wire is formed in the package circuit wire substrate. The package circuit wire is connected to the metal circuit pattern and the mother board circuit wire.

The semiconductor package may comprise a first semiconductor package and a second semiconductor package. The first semiconductor package may be mounted on one side of the package circuit wire substrate, and the second semiconductor package may be mounted on the other side of the package circuit wire substrate.

The resin may be formed such that the resin is attached to at least a portion of the metal circuit pattern and at least a portion of the integrated circuit unit, the resin physically connecting the integrated circuit unit to the metal circuit pattern.

The integrated circuit unit may comprise at least one integrated circuit chip.

The integrated circuit unit may comprise a first integrated circuit chip and a second integrate circuit chip. The first integrated circuit chip may be wire bonded to the metal circuit pattern, and the second integrated circuit chip may be flip chip bonded to the metal circuit pattern.

It is to be understood that both the foregoing general description and the following detailed description are exemplary and explanatory and are intended to provide further explanation of the invention as claimed.

### Brief description of the drawings

The invention will be described in detail with reference to the following drawings in which like numerals refer to like elements.
FIG. 1 is a cross sectional diagram illustrating a conventional semiconductor apparatus whose semiconductor package is mounted on a mother board in a surface mount technology type;
FIG. 2 is a cross sectional diagram illustrating a semiconductor package according to an exemplary embodiment of the present invention;
FIGS. 3 to 6 illustrate a semiconductor package manufacturing method according to an exemplary embodiment of the present invention;
FIG. 7 is a cross sectional diagram illustrating a semiconductor apparatus according to a first exemplary embodiments of the present invention;
FIG. 8 is a cross sectional diagram illustrating a semiconductor apparatus according to a second exemplary embodiments of the present invention;
FIG. 9 is a cross sectional diagram illustrating a semiconductor apparatus according to a third exemplary embodiments of the present invention;
FIG. 10 is a cross sectional diagram illustrating a semiconductor apparatus according to a fourth exemplary embodiments of the present invention; and
FIG. 11 is a cross sectional diagram illustrating a semiconductor apparatus according to a fifth exemplary embodiments of the present invention.

### Detailed description

Preferred embodiments of the present invention will be described in a more detailed manner with reference to the drawings.

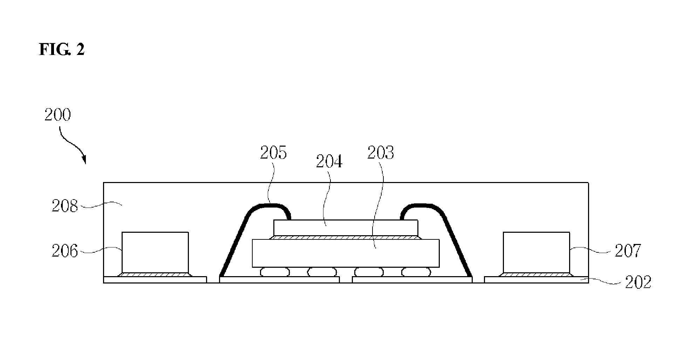

FIG. 2 is a cross sectional diagram illustrating a semiconductor package according to an exemplary embodiment of the present invention. As shown in FIG. 2, the semiconductor package 200 according to an exemplary embodiment of the present invention comprises a metal circuit pattern 202, a first integrated circuit chip 203, a second integrated circuit chip 204, a bonding wire 205, an active device 206, a passive device 207, and a resin 208.

The metal circuit pattern 202 is a means for electrical connecting to an outer device. The outer device may be a mother board.

The first integrated circuit chip 203 is electrically connected to the metal circuit pattern 202 by flip chip bonding.

The second integrated circuit chip 204 is positioned over the first integrated circuit chip 203. There can be an adhesive means between the first integrated circuit chip 203 and the second integrated circuit chip 204.

The bonding wire 205 electrically connects the second integrated circuit chip 204 to the metal circuit pattern 202.

The active device 206 and the passive device 207 are electrically connected to the metal circuit pattern 202.

The resin 208 is formed such that the resin 208 is attached to at least a portion of the metal circuit pattern 202 and at least a portion of the integrated circuit unit 203, 204, the resin 208 physically connecting the integrated circuit unit 203, 204 to the metal circuit pattern 202. In more detail, the resin 208 at least partially surrounds the metal circuit pattern 202, the first integrated circuit chip 203, the second integrated circuit chip 204, the bonding wire 205, the active device 206, and the passive device 207. Accordingly, the resin 208 physically supports the semiconductor package 200, and protects the semiconductor package 200 from physical impact, electromagnetic interference, etc.

The semiconductor package 200 according to an exemplary embodiment of the present invention does not require package substrate. Thus, the thickness of the semiconductor package 200 according to an exemplary embodiment of the present invention decreases to an extent of the thickness D of the package substrate 11, which is included in the conventional semiconductor package 10 shown FIG. 1.

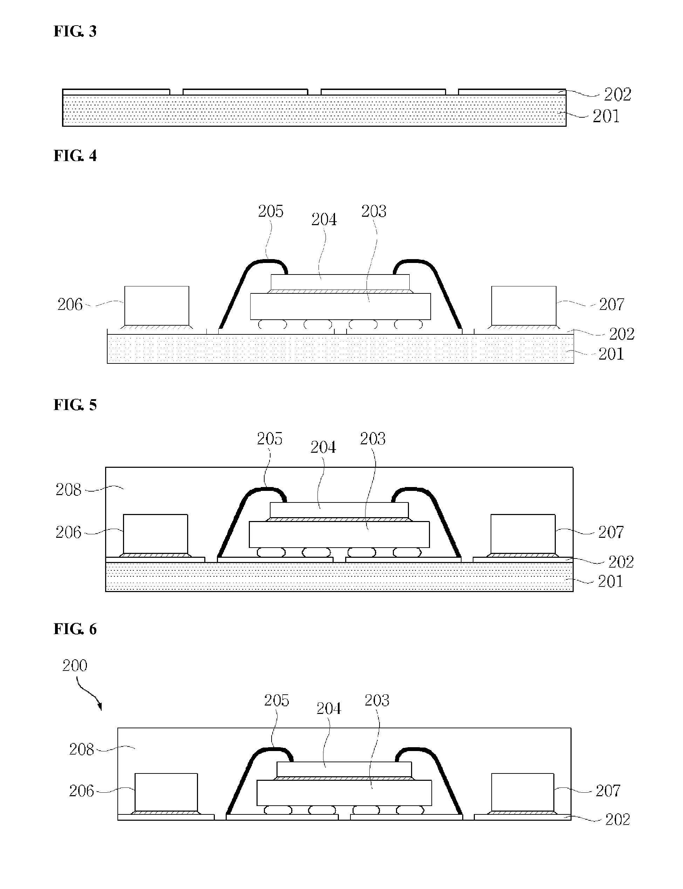

FIGS. 3 to 6 illustrate a semiconductor package manufacturing method according to an exemplary embodiment of the present invention. As shown FIGS. 3 to 6, the semiconductor package manufacturing method according to an exemplary embodiment of the present invention comprises a step of forming a metal circuit pattern 202 on a substrate 201, a step of connecting a integrated circuit unit 203, 204 to the metal circuit pattern 202, a step of forming a resin 208 on the substrate 201, the metal circuit pattern 202 and the integrated circuit unit 203, 204 and a step of removing the substrate 201.

### <the step of forming the metal circuit pattern 202>

As shown FIG. 3, the metal circuit pattern 202 is formed on the substrate 201. The substrate 201 may be copper. Although not shown FIG. 3, the metal circuit pattern 202 may be formed by following procedures. For one example, 1) a photo resist layer may be formed on the substrate 201, 2) a photo resist pattern may be formed by a lithography method, 3) the metal circuit pattern 202 may be formed by etching the substrate 201 according to the photo resist pattern or the metal circuit pattern 202 may be formed by a screen printing method according to the photo resist pattern.

### <the step of connecting the integrated circuit unit 203, 204 to the metal circuit pattern 202>

As shown FIG. 4, the integrated circuit unit 203, 204 comprising a first integrated circuit chip 203 and a second integrated circuit chip 204 is connected to the metal circuit pattern 202. The first integrated circuit chip 203 is connected to the metal circuit pattern 202 by flip chip bonding. The second integrated circuit chip 204 is positioned over the first integrated circuit chip 203. There can be an adhesive means between the first integrated circuit chip 203 and the second integrated circuit chip 204. The second integrated circuit chip 204 is connected to the metal circuit pattern 202 by the bonding wire 205. In addition, at least one of an active device 206 and a passive device 207 may be connected to the metal circuit pattern 202.

### <the step of forming the resin 208>

As shown FIG. 5, the resin 208 is formed on the substrate 201, the metal circuit pattern 202 and the integrated circuit unit 203, 204. A construction material of the resin 208 may be an epoxy resin. More desirably, the resin 208 may be formed such that the resin 208 is attached to at least a portion of the metal circuit pattern 202 and at least a portion of the integrated circuit unit 203, 204, the resin 208 physically connecting the integrated circuit unit 203, 204 to the metal circuit pattern 202. In more detail, the resin 208 may be formed at least partially surrounding the metal circuit pattern 202, the first integrated circuit chip 203, the second integrated circuit chip 204, the bonding wire 205, the active device 206, and the passive device 207. Accordingly, the resin 208 physically supports the semiconductor package 200, and protects the semiconductor package 200 from physical impact, electromagnetic interference, etc.

### <the step of removing the substrate 201 >

As shown FIG. 6, the substrate 201 is removed from the semiconductor package 200.

As described above, the semiconductor package 200 manufactured according to the present invention does not require package substrate. Thus, the thickness of the semiconductor package 200 manufactured according to the present invention decreases to an extent of the thickness D of the package substrate 11, which is included in the conventional semiconductor package 10 shown FIG. 1.

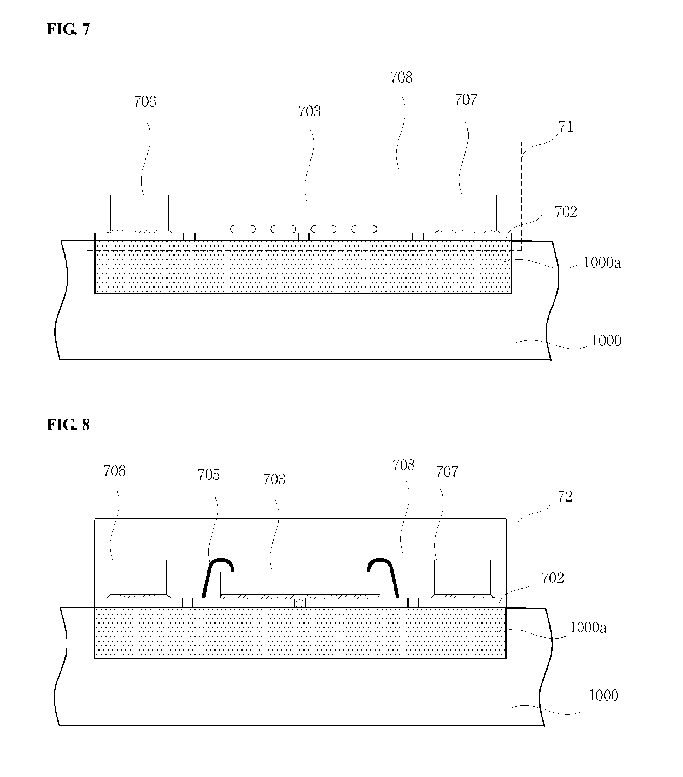

FIG. 7 is a cross sectional diagram illustrating a semiconductor apparatus according to a first exemplary embodiment of the present invention. As shown FIG. 7, the semiconductor apparatus according to a first exemplary embodiment of the present invention comprises a semiconductor package 71 and a mother board 1000.

The semiconductor package 71 comprises a metal circuit pattern 702, an integrated circuit unit 703 connected to the metal circuit pattern 702 and a resin 708 formed on the metal circuit pattern 702 and the integrated circuit unit 703. The semiconductor package 71 comprised in the semiconductor apparatus according to a first exemplary embodiment of the present invention is similar in a structure and function with the above-described semiconductor package 200 according to an exemplary embodiment of the present invention. Thus, its detailed description will be omitted and replaced with the description of semiconductor package 200 according to an exemplary embodiment of the present invention.

The mother board 1000 comprises a package circuit wire(not shown) connected to the metal circuit pattern 702 and a mother board circuit wire(not shown) connected to the package circuit wire.

The package circuit wire is an electrical connecting means to drive the semiconductor package 71. The package circuit wire is constructed in a mother board region 1000a under a surface mount technology region where the semiconductor package 71 is mounted. Thus, the thickness of the semiconductor apparatus according to the present invention decreases to an extent of the thickness D of the package substrate 11, which is included in the conventional semiconductor package 10 shown FIG. 1.

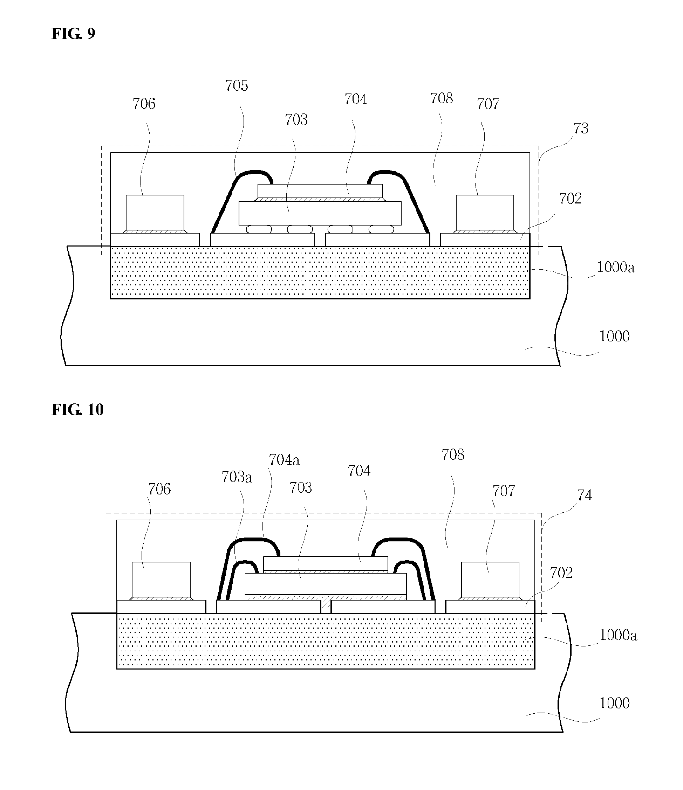

FIG. 8 is a cross sectional diagram illustrating a semiconductor apparatus according to a second exemplary embodiment of the present invention. As shown FIG. 8, an integrated circuit unit 703 is electrically connected to the metal circuit pattern 702 by flip chip bonding.

FIG. 9 is a cross sectional diagram illustrating a semiconductor apparatus according to a third exemplary embodiment of the present invention. As shown FIG. 9, a first integrated circuit chip 703 is electrically connected to a metal circuit pattern 702 by flip chip bonding. A second integrated circuit chip 704 is positioned over the first integrated circuit chip 703. There can be an adhesive means between the first integrated circuit chip 703 and the second integrated circuit chip 704. A bonding wire 705 electrically connects the second integrated circuit chip 704 to the metal circuit pattern 702.

FIG. 10 is a cross sectional diagram illustrating a semiconductor apparatus according to a fourth exemplary embodiment of the present invention. As shown FIG. 10, a first bonding wire 703a electrically connects a first integrated circuit chip 703 to a metal circuit pattern 702. A second bonding wire 704a electrically connects a second integrated circuit chip 704 to the metal circuit pattern 702.

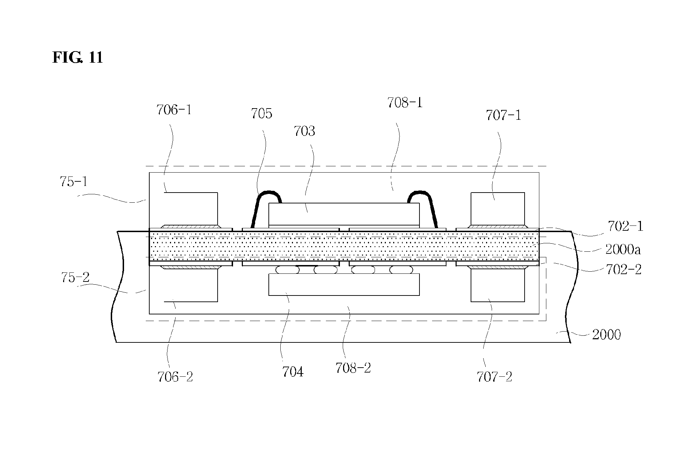

FIG. 11 is a cross sectional diagram illustrating a semiconductor apparatus according to a fifth exemplary embodiment of the present invention. As shown FIG. 11, the semiconductor apparatus according to the fifth exemplary embodiment of the present invention comprises a first semiconductor package 75-1, a second semiconductor package 75-2, a mother board 2000 and a package circuit wire substrate 2000a.

The first semiconductor package 75-1 comprises a first metal circuit pattern 702-1, a first integrated circuit chip 703 formed on the first metal circuit pattern 702-1, and a first resin 708-1 formed on the first metal circuit pattern 702-1 and the first integrated circuit chip 703.

The second semiconductor package 75-2 comprises a second metal circuit pattern 702-2, a second integrated circuit chip 704 formed on the second metal circuit pattern 702-2, and a second resin 708-2 formed on the second metal circuit pattern 702-2 and the second integrated circuit chip 704.

The mother board 2000 comprises a mother board circuit wire(not shown). A groove is formed on the mother board 2000.

The package circuit wire substrate 2000a comprises a package circuit wire(not shown) and is mounted on the groove.

The first semiconductor package 75-1 is mounted on one side of the package circuit wire substrate 2000a. The package circuit wire formed in the package circuit wire substrate 2000a is connected to the first metal circuit pattern 702-1 and the mother board circuit wire.

The second semiconductor package 75-2 is mounted on the other side of the package circuit wire substrate 2000a. The package circuit wire formed in the package circuit wire substrate 2000a is connected to the second metal circuit pattern 702-2 and the mother board circuit wire.

According to the above described fifth exemplary embodiment of the present invention, the thickness of a semiconductor apparatus decreases. Thus, provided is a semiconductor apparatus having a compact structure.

The invention being thus described, it will be obvious that the same may be varied in many ways. Such variations are not to be regarded as a departure from the spirit and scope of the invention, and all such modifications as would be obvious to one skilled in the art are intended to be included within the scope of the following claims.

## Claims

1. A semiconductor package manufacturing method, comprising:
forming a metal circuit pattern on a substrate;
connecting an integrated circuit unit to said metal circuit pattern;
forming a resin on said substrate, said metal circuit pattern and said integrated circuit unit; and
removing said substrate.

2. The semiconductor package manufacturing method of claim 1, wherein said resin is formed such that said resin is attached to at least a portion of said metal circuit pattern and at least a portion of said integrated circuit unit, said resin physically connecting said integrated circuit unit to said metal circuit pattern.

3. The semiconductor package manufacturing method of claim 1, wherein said integrated circuit unit comprises at least one integrated circuit chip.

4. The semiconductor package manufacturing method of claim 1, wherein said integrated circuit unit comprises a first integrated circuit chip and a second integrated circuit chip, wherein said first integrated circuit chip is flip chip bonded to said metal circuit pattern and said second integrated circuit chip is wire bonded to said metal circuit pattern.

5. The semiconductor package manufacturing method of claim 1, further comprising connecting at least one of an active device and a passive device to the metal circuit pattern.

6. A semiconductor apparatus, comprising:
a semiconductor package comprising a metal circuit pattern, an integrated circuit unit connected to said metal circuit pattern and a resin formed on said metal circuit pattern and said integrated circuit unit; and
a mother board comprising a package circuit wire connected to said metal circuit pattern and a mother board circuit wire connected to said package circuit wire.

7. The semiconductor apparatus of claim 6, wherein said package circuit wire is an electrically connecting means for driving the semiconductor package.

8. The semiconductor apparatus of claim 6, wherein said resin is formed such that said resin is attached to at least a portion of said metal circuit pattern and at least a portion of said integrated circuit unit, said resin physically connecting said integrated circuit unit to said metal circuit pattern.

9. The semiconductor apparatus of claim 6, wherein said integrated circuit unit comprises at least one integrated circuit chip.

10. The semiconductor apparatus of claim 6, wherein said integrated circuit unit comprises a first integrated circuit chip and a second integrated circuit chip, wherein said first integrated circuit chip is flip chip bonded to said metal circuit pattern and said second integrated circuit chip is wire bonded to said metal circuit pattern.

11. A semiconductor apparatus, comprising: a semiconductor package comprising a metal circuit pattern, an integrated circuit unit connected to said metal circuit pattern and a resin formed on said metal circuit pattern and said integrated circuit unit;
a mother board comprising a groove and a mother board circuit wire; and
a package circuit wire substrate mounted on said groove, wherein said package circuit wire is formed in said package circuit wire substrate, and wherein said package circuit wire is connected to said metal circuit pattern and said mother board circuit wire.

12. The semiconductor apparatus of claim 11, wherein said semiconductor package comprises a first semiconductor package and a second semiconductor package, wherein said first semiconductor package is mounted on one side of said package circuit wire substrate and said second semiconductor package is mounted on the other side of said package circuit wire substrate.

13. The semiconductor apparatus of claim 11, wherein said resin is formed such that said resin is attached to at least a portion of said metal circuit pattern and at least a portion of said integrated circuit unit, said resin physically connecting said integrated circuit unit to said metal circuit pattern.

14. The semiconductor apparatus of claim 11, wherein said integrated circuit unit comprises at least one integrated circuit chip.

15. The semiconductor apparatus of claim 11, wherein said integrated circuit unit comprises a first integrated circuit chip and a second integrated circuit chip, wherein said first integrated circuit chip is wire bonded to said metal circuit pattern and said second integrated circuit chip is flip chip bonded to said metal circuit pattern.
